(19) Europäisches Patentamt / European Patent Office / Office européen des brevets

(11) EP 1 321 974 B1

(12) EUROPEAN PATENT SPECIFICATION

(45) Date of publication and mention of the grant of the patent: **08.10.2014 Bulletin 2014/41**

(21) Application number: **01958571.0**

(22) Date of filing: **28.08.2001**

(51) Int Cl.:
***H01L 21/02*** (2006.01) ***C09D 183/16*** (2006.01)
***H01L 21/316*** (2006.01)

(86) International application number: **PCT/JP2001/007380**

(87) International publication number: **WO 2002/019410 (07.03.2002 Gazette 2002/10)**

(54) **POROUS SILICEOUS FILM HAVING LOW PERMITTIVITY, SEMICONDUCTOR DEVICES AND COATING COMPOSITION**

PORÖSER SILIZIUMOXIDFILM MIT NIEDRIGER PERMITIVITÄT, HALBLEITERBAUELEMENTE UND BESCHICHTUNGSZUSAMMENSETZUNG

FILM SILICEUX POREUX POURVU D'UNE FAIBLE PERMITTIVITE, DISPOSITIFS SEMI-CONDUCTEURS ET COMPOSITION DE REVETEMENT

(84) Designated Contracting States: **AT BE CH CY DE DK ES FI FR GB GR IE IT LI LU MC NL PT SE TR**

(30) Priority: **29.08.2000 JP 2000259531**

(43) Date of publication of application: **25.06.2003 Bulletin 2003/26**

(73) Proprietor: **AZ Electronic Materials USA Corp.**
**Somerville, NJ 08876 (US)**

(72) Inventors:
- **AOKI, Tomoko,**
**C/O Clariant (Japan) K.K.**
**Tokyo 113-8662 (JP)**
- **SHIMIZU, Yasuo,**
**c/o Clariant (Japan) K.K**
**Shizuoka 437-1496 (JP)**

(74) Representative: **Isenbruck, Günter et al**
**Isenbruck Bösl Hörschler LLP**
**Eastsite One**
**Seckenheimer Landstrasse 4**
**68163 Mannheim (DE)**

(56) References cited:

| | |
|---|---|
| **EP-A- 1 232 998** | **WO-A1-01/04049** |
| **JP-A- 7 292 321** | **JP-A- 7 292 321** |
| **JP-A- 11 105 185** | **JP-A- 11 105 186** |

- **AOKI T ET AL: "POROUS SILICON OXYNITRIDE FILMS DERIVED FROM POLYSILAZANE AS A NOVEL LOW-DIELECTRIC CONSTANT MATERIAL" MAT. RES. SOC. SYMP. PROC., vol. 565, 1999, pages 41-46, XP002509738**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### TECHNICAL FIELD

The present invention relates to a method for preparing a porous silica coating with a low dielectric constant.

### BACKGROUND ART

Polysilazane coatings are converted into silica coatings by firing in atmospheric air. These silica coatings are used as an interlayer dielectric for semiconductors because of their excellent electrical insulating properties. Among these silica coatings, a completely inorganic silica coating has already been employed as an excellent interlayer dielectric for a semiconductor because it has high heat resistance and can be used in a non-etch back process. In this case, the physical properties of the silica coating are similar to those of silicon dioxide ($SiO_2$) and its dielectric constant is within a range from 3.0 to 4.7.

With the increase of the speed and integration density of integrated circuits, a further reduction in dielectric constant is required of electronic materials such as an interlayer dielectric. However, the specific dielectric constant of a conventional silica coating is too high for such a requirement. It is known to make the silica coating porous so as to reduce the specific dielectric constant, however, the silica coating generally has moisture absorption properties and the specific dielectric constant increases, over time, under an ambient atmosphere. It has been proposed that a porous coating is subjected to a water repellent treatment thereby to add an organic group such as a trimethylsilyl group to the surface in order to prevent an increase in specific dielectric constant, over time, due to moisture absorption. However, such an additional water repellent treatment causes the problem that the manufacturing cost increases and, therefore, it is not desirable.

As another method for preventing an increase in specific dielectric constant, over time, it has been proposed that an organic silica coating obtained by baking a polyorganosilazane is made porous. The structure in which an organic group is directly bonded to a silicon atom in silica provides a porous coating having high water repellency, which prevents an increase in specific dielectric constant, over time, due to moisture absorption, and also having a thermal resistance and an environmental resistance which are required of an interlayer dielectric for a semiconductor.

A further increase of the integration density of integrated circuits demands development of a groove wiring technique for more efficiently achieving reduction in size, and multilayering, of internal wiring in a semiconductor device. The groove wiring technique is one which forms groove wiring by preforming a predetermined groove in an interlayer dielectric, embedding a wiring material such as an Al alloy and Cu in the groove by a sputter-reflow process or a CVD process, and removing the wiring material deposited outside the groove by a CMP (Chemical Mechanical Polishing) process or the like, as represented by the Damascene process. The advance of such a groove wiring technique allows further reduction in size of the internal wiring in semiconductor devices, and surface flattening by a CMP process allows further multilayering.

Such an increase of the integration density of integrated circuits demands, from an interlayer dielectric existing between wires, a further reduction in dielectric constant, a mechanical strength which allows the interlayer dielectric to withstand the step of removing the wiring material by a CMP process, and resistance to various chemicals such as agents used in a CMP process, agents used in a step of removing a photoresist by wet stripping, and agents for removing residues after ashing in removing a photoresist by ashing. However, it is impossible to satisfy all of the above demands, because a conventional porous silica coating has the problem that the specific dielectric constant increases, over time, due to moisture absorption, and because a conventional porous organic silica coating has the problem that the above-described mechanical strength and chemical resistance are not necessarily sufficient.

Thus, an object of the present invention is to provide a porous silica coating suitable for an interlayer dielectric, which stably exhibits an extremely low specific dielectric constant (especially of less than 2.5) and which also has resistance to various chemicals and a mechanical strength allowing the coating to withstand the latest highly integrating process including the Damascene process. Another object of the present invention is to provide a coating composition which provides the porous silica coating.

### DISCLOSURE OF THE INVENTION

According to the present invention as claimed in claim 1, there is provided a porous silica coating having a specific a method for preparing dielectric constant of less than 2.5, by baking a coating of a composition comprising a polyalkylsilazane and a polyacrylic or polymethacrylic ester.

There is also provided a method for preparing a porous silica coating comprising pre-baking a polyalkylsilazane coating, which is obtained by coating the coating composition on a substrate, in a water vapor-containing atmosphere at a temperature of from 50 to 300°C, and then baking the coating in a dry atmosphere at a temperature of from 300 to

500°C.

MODE FOR CARRYING OUT THE INVENTION

A porous silica coating is obtained by baking a coating of a composition comprising a polyalkylsilazane and a polyacrylic or polymethacrylic ester. The polyalkylsilazane has in its molecular chain a repeating unit represented by the following general formula (1) and a number-average molecular weight within a range from 100 to 50,000:

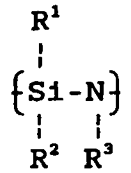 (1)

wherein, $R^1$, $R^2$ and $R^3$ each independently represents a hydrogen atom or an alkyl group having 1 to 3 carbon atoms, provided that $R^1$ and $R^2$ cannot be hydrogen atoms at the same time.

The alkyl group includes a methyl group, an ethyl group and a propyl group. The particularly preferable alkyl group is a methyl group. In this connection, a polyalkylsilazane which contains an alkyl group having 4 or more carbon atoms is not desirable, because the resulting porous coating is too soft.

The polyalkylsilazane defined by the above formula (1) wherein $R^1$ and $R^2$ each independently is a hydrogen atom or a methyl group, provided that $R^1$ and $R^2$ cannot be hydrogen atoms at the same time, and $R^9$ is a hydrogen atom, is particularly preferable.

The particularly preferable polyalkylsilazane has in its molecular chain a repeating unit represented by the following general formula (2) and a number-average molecular weight within a range from 100 to 50,000:

$$-(SiR^4(NR^5)_{1.5})- \qquad (2)$$

wherein, $R^4$ and $R^5$ each independently represents a hydrogen atom or an alkyl group having 1 to 3 carbon atoms, provided that $R^4$ and $R^5$ cannot be hydrogen atoms at the same time.

The alkyl group is defined as described above for formula (1). The polyalkylsilazane defined by the above formula (2) wherein $R^4$ is a methyl group and $R^5$ is a hydrogen atom, is particularly preferable.

The polyalkylsilazane containing both of the repeating units represented by the above formulae (1) and (2) is particularly useful in that gelation upon storage of the composition is prevented. In this case, it is preferable that the number of repeating units represented by the formula (2) comprises at least 50%, preferably at least 80%, and more preferably at least 90% of the total number of repeating units represented by the formulae (1) and (2).

These polyalkylsilazanes can be obtained by ammonolysis used in preparing a well-known polysilazane, wherein as a starting material is used a dialkyldichlorosilane ($R^1R^2SiCl_2$) in case of the polyalkylsilazane containing the repeating unit of formula (1), an alkyltrichlorosilane ($R^4SiCl_3$) in case of the polyalkylsilazane containing the repeating unit of formula (2), and a mixture of the dialkyldichlorosilane and the alkyltrichlorosilane in case of the polyalkylsilazane containing both of these repeating units. For the polyalkylsilazane containing both of the repeating units represented by formulae (1) and (2), the mixing ratio of the dialkyldichlorosilane and the alkyltrichlorosilane determines the ratio of presence for these units.

Addition, to the above polyalkylsilazane, of an aluminum compound in a form which is soluble in an organic solvent, produces an aluminum-containing polyalkylsilazane which does not form an aluminopolyalkylsilazane structure wherein aluminum and silicon are firmly combined. The aluminum compound in a form which is soluble in an organic solvent includes an alkoxide, a chelated compound, an organic aluminum, a halide, and the like. The added amount of the aluminum compound varies depending on the kind, but is within the range from 0.001 to 10% by weight, preferably from 0.01 to 10% by weight, as aluminum, on the basis of the polysilazane. For the details of the aluminum-containing polyalkylsilazane, reference should be made to the Japanese Unexamined Patent Publication No. 11-105185.

The polyalkylsilazane is dissolved in an organic solvent, preferably an inert organic solvent free from active hydrogen, for use. Examples of such an organic solvent include an aromatic hydrocarbon solvent such as benzene, toluene, xylene, ethylbenzene, diethylbenzene, trimethylbenzene, or triethylbenzene; an alicyclic hydrocarbon solvent such as cyclohexane, cyclohexene, decahydronaphthalene, ethylcyclohexane, methylcyclohexane, p-menthine, or dipentene (limonene); an ether solvent such as dipropyl ether or dibutyl ether; and a ketone solvent such as methyl isobutyl ketone.

The coating composition is obtained by adding a polyacrylic or polymethacrylic ester to an organic solvent solution containing the polyalkylsilazane as described above.

The polyacrylic or polymethacrylic ester, which is useful in the present invention, is a homopolymer or copolymer of a polyacrylic or polymethacrylic ester, and specific examples thereof include polymethyl acrylate, polyethyl acrylate, polybutyl acrylate, polymethyl methacrylate, polyethyl methacrylate, polybutyl methacrylate, polyisobutyl methacrylate, and block copolymers and other copolymers thereof.

As the polyacrylic or polymethacrylic ester, those having a number-average molecular weight within a range from 1,000 to 800,000 can be used. When the number-average molecular weight is smaller than 1,000, a porous coating is not formed because the polyacrylic or polymethacrylic ester is sublimated at low temperature. When the number-average molecular weight exceeds 800,000, the pore size increases to cause voids, thus reducing the coating strength. Therefore, both cases are not preferred. The number-average molecular weight of the polyacrylic or polymethacrylic ester in the present invention is preferably within a range from 10,000 to 600,000, and particularly preferred results are obtained when the number-average molecular weight is within a range from 50,000 to 300,000.

The amount of the polyacrylic or polymethacrylic ester in the present invention is controlled within a range from 5 to 150% by weight based on the polyalkylsilazane used. When the amount of the polyacrylic or polymethacrylic ester is smaller than 5% by weight, the coating is insufficiently made porous. On the other hand, when the amount is larger than 150% by weight, defects such as voids and cracks occur, thereby to reduce the coating strength. Therefore, it is not preferred. The amount of the polyacrylic or polymethacrylic ester is preferably within a range from 10 to 120% by weight, and particularly preferred results are obtained when the amount is within a range from 20 to 100% by weight.

The polyacrylic or polymethacrylic ester is generally added to the polyalkylsilazane solution in the form of a solution prepared by dissolving the polyester in an organic solvent. In this case, the same organic solvent as that used in preparation of the polyalkylsilazane solution may be used as the organic solvent. As the organic solvent in which the polyacrylic or polymethacrylic ester is dissolved, an inert organic solvent free from active hydrogen described above is used. When using the polyacrylic or polymethacrylic ester after dissolving in the organic solvent, the concentration of the polyacrylic or polymethacrylic ester can be controlled within a range from 5 to 80% by weight, and preferably from 10 to 40% by weight. A homogeneous solution can be obtained by physically stirring after the addition of the polyacrylic or polymethacrylic ester. The polyacrylic or polymethacrylic ester itself can also be added and dissolved in the polyalkylsilazane solution.

The resulting organic solvent solution containing the polyalkylsilazane and the polyacrylic or polymethacrylic ester can be coated on the surface of a substrate by using it as a coating composition with or without controlling the concentration of the polyalkylsilazane.

Examples of the method of coating the coating composition containing the polyalkylsilazane and the polyacrylic or polymethacrylic ester to the surface of the substrate include conventionally known methods, for example, spin coating method, dipping method, spraying method, and transferring method.

The polyalkylsilazane coating formed on the surface of the substrate is baked in various atmospheres. The atmosphere includes, for example, an atmosphere which scarcely contains water vapor, such as dry air, dry nitrogen, or dry helium, or an atmosphere containing water vapor, such as atmospheric air, moistened atmospheric air, or moistened nitrogen. The baking temperature is within a range from 50 to 600°C, and preferably from 300 to 500°C, and the baking time is within a range from one minute to one hour. silica coating

A silica coating having a low dielectric constant and a good coating quality is advantageously prepared by forming a polyalkylsilazane coating on the surface of a substrate, preliminary heating the coating in a water vapor-containing atmosphere, leaving the coating to stand in atmospheric air for a long period of time (for example, 24 hours), and baking the coating by heating in a dry atmosphere. In this case, in the water vapor-containing atmosphere, the water vapor content is 0.1 volume % or more, and preferably 1 volume % or more. Examples of such an atmosphere include atmospheric air, moistened atmospheric air, and moistened nitrogen gas. In the dry atmosphere, the water vapor content is 0.5 volume % or less, and preferably 0.05 volume % or less. Examples of the dry atmosphere include dry air, nitrogen gas, argon gas, and helium gas. The preliminary heating temperature is within a range from 50 to 300°C. The baking temperature is within a range from 100 to 500°C, and preferably from 300 to 500°C.

In the baking described above, only an Si-N bond, among Si-H, Si-R (R: hydrocarbon group) and Si-N bonds, in the polyalkylsilazane is oxidized and converted into an Si-O bond to form a silica coating containing unoxidized Si-H and Si-R bonds. In particular, in case of the baking of the aluminum-containing polyalkylsilazane coating with heating, preferential oxidation of the Si-N bond proceeds by a catalytic action of aluminum, even without leaving the coating to stand in atmospheric air for a long period of time. Thus, the present invention allows the Si-O bond formed by selectively oxidizing the Si-N bond, and the unoxidized Si-H and Si-R bonds, to exist in the formed silica coating, thereby making it possible to obtain a silica coating with a low density. Generally, the dielectric constant of the silica coating is reduced with the reduction of the coating density, while adsorption of water as a high dielectric substance occurs when the coating density is reduced. Therefore, there arises a problem that the dielectric constant increases when the silica coating is left to stand in atmospheric air. In the case of the silica coating containing Si-H and Si-R bonds, adsorption of water can be prevented regardless of low density because these bonds have water repellency. Therefore, the silica coating of the present invention has a large merit that the dielectric constant of the coating scarcely increases even if the silica coating

is left to stand in atmospheric air containing water vapor. The silica coating also has a merit that it is less likely to cause cracking because the internal stress of the coating is small due to low density.

In the baking of the coating, micropores having a diameter of 5 to 30 nm are formed in the silica coating by sublimation of the polyacrylic or polymethacrylic ester in the coating. The existence of the micropores further reduces the density of the silica coating, and thus the specific dielectric constant of the silica coating is further reduced. This is because the compatibility between the polyalkylsilazane and the polyacrylic or polymethacrylic ester is very good. The use of the polyacrylic or polymethacrylic ester prevents the Si-OH bond from forming in the polyalkylsilazane during the baking of the coating. Therefore, the silica coating maintains the water repellency, and the specific dielectric constant reduced due to the micropores scarcely increases even when left to stand in atmospheric air containing water vapor. As described above, according to the present invention, it is made possible to obtain a porous silica coating capable of stably maintaining a very low specific dielectric constant of less than 2.5, preferably 2.0 or less, occasionally about 1.6, in cooperation with the reduction in density and impartation of water repellency due to the bond components (SiH, SiR) of the silica coating as well as reduction in density of the whole coating due to micropores. Therefore, as a water repellent treatment required to prevent moisture absorption in a conventional porous silica coating is not required, it becomes advantageous in view of the manufacturing cost, and an inorganic material's merit is not impaired by the introduction of an organic group.

The porous silica coating has resistance to various chemicals and a mechanical strength which allow the coating to withstand the step of removing wiring materials by CMP process, and therefore it can be used as an interlayer dielectric which is compatible with the latest highly integrating processes including the Damascene process. Specifically, the porous silica coating has a modulus determined by a nanoindentation method, described below, of 2.5 GPa or higher, i.e. a significantly high mechanical strength for a porous material, as well as an etching rate determined by a remover for etch residues described below of 1.0Å/min or less, and preferably 0.8Å/min or less, i.e. high resistance to various chemicals.

Referring to other properties of the porous silica coating, the density is within a range from 0.5 to 1.4 $g/cm^3$, and preferably from 0.7 to 1.1 $g/cm^3$, and the cracking limitation in coating thickness is 1.0 μm or more, and preferably 10 μm or more and, furthermore, the internal stress is 2.0 x $10^4$ $N/cm^2$ or less, and preferably $1.0 \times 10^4$ $N/cm^2$ or less. The content of Si, which exists in the form of a Si-H or Si-R bond (R: hydrocarbon group), in the silica coating is within a range from 10 to 100 atomic %, and preferably from 25 to 75 atomic %, based on the number of Si atoms contained in the silica porous coating. The content of Si, which exists in the form of a Si-N bond, is 5 atomic % or less.

The thickness of the porous silica coating obtained after baking varies depending on the purposes of the substrate surface, but is usually within a range from 0.01 to 5 μm, and preferably from 0.1 to 2 μm. When used as an interlayer dielectric, the thickness is within a range from 0.1 to 2 μm.

As described above, the porous silica coating has a low density and has a merit that a cracking limitation in coating thickness, namely, a maximum coating thickness where a coating can be formed without causing cracking of the coating is 5 μm or more. In case of a conventional silica coating, the cracking limitation in coating thickness is within a range from about 0.5 to 1.5 μm. Therefore, the silica coating described here exhibits a large technical effect as compared with a conventional silica coating.

Herein is provided a porous silica coating having a well-balanced combination of properties of a stable low specific dielectric constant, a mechanical strength which allows the coating to withstand the latest microwiring process, and resistance to various chemicals. Use of the porous silica coating as an interlayer dielectric in a semiconductor device makes it possible to achieve further increase of the integration density, and further multilayering, of integrated circuits.

In addition to the use as an interlayer dielectric, a silica coating can be formed on the solid surface of various materials such as metal, ceramics or lumber by using the coating composition of the present invention. According to the present invention, there are provided a metal substrate (silicon, stainless steel (SUS), tungsten, iron, copper, zinc, brass, or aluminum) with a silica coating formed thereon, and a ceramic substrate (metal oxide such as silica, alumina, magnesium oxide, titanium oxide, zinc oxide and tantalum oxide, metal nitride such as silicon nitride, boron nitride and titanium nitride, or silicon carbide) with a silica coating formed thereon.

The following Examples illustrate experiments with coatings.

The method of evaluating physical properties of the silica coating is as follows.

(Specific Dielectric constant)

A Pyrex glass plate (thickness: 1 mm, size: 50 mm × 50 mm) manufactured by Dow Corning Inc. was sufficiently washed, in order, with a neutral detergent, an aqueous diluted NaOH solution and an aqueous diluted $H_2SO_4$ solution, and then dried. An Al coating (0.2 μm) was formed on the whole surface of the glass plate by a vacuum deposition method. After coating the glass plate with a polyalkylsilazane solution by a spin coating method, the resulting polyalkylsilazane coating (about 3 mm × 3 mm in size) was removed by rubbing, with a rod applicator, from four corners of the glass plate to form portions for taking out electric signals. Subsequently, the coating was converted into a silica coating

in accordance with the method of the Examples or Comparative Examples. The resulting silica coating was covered with a mask of SUS and an Al coating was formed by a vacuum deposition method (18 patterns in the form of square of 2 mm × 2 mm, 2 μm in thickness). A capacitance was measured by an impedance analyzer 4192 ALF manufactured by YHP Inc. (100 kHz). The thickness of the coating was measured by a spectroellipsometer (M-44 manufactured by J.A. Woollam Inc.). The specific dielectric constant was calculated using the following equation.

$$\text{Specific dielectric constant} = (\text{Capacitance [pF]}) \times (\text{Coating thickness } [\mu m])/35.4$$

The specific dielectric constant was determined by calculating an average of 18 measured values.

(Coating density)

The weight of a silicon wafer, 4 inch (10.16 cm) in diameter and 0.5 mm in thickness, was measured by an electric balance. After coating the silicon wafer with a polyalkylsilazane solution by a spin coating method, the resulting polysilazane coating was converted into a silica coating in accordance with the method of the Examples or Comparative Examples and the weight of the coated silicon wafer was measured again by the electric balance. A difference in weight was taken as the weight of the coating. In the same manner as in case of the evaluation of the specific dielectric constant, the thickness of the coating was measured by a a spectroellipsometer (M-44 manufactured by J.A. Woollam Inc.). The coating density was calculated by the following equation.

$$\text{Coating density [g/cm}^3\text{]} = (\text{Coating weight [g]}) \times (\text{Coating thickness } [\mu m])/0.008.$$

(Internal stress)

Data on warping of a silicon wafer, 4 inch (10.16 cm) in diameter and 0.5 mm in thickness, were input in a laser internal stress measurement system Model FLX-2320 manufactured by Tencor Corporation. After coating the silicon wafer with a polyalkylsilazane solution by a spin coating method, the resulting coating was converted into a silica coating in accordance with the method of the Examples or Comparative Examples and cooled to room temperature (23°C). Then, the internal stress was measured by the laser internal stress measurement system Model FLX-2320 manufactured by Tencor Corporation. In the same manner as in case of the evaluation of the specific dielectric constant, the thickness of the coating was measured by a spectroellipsometer (M-44 manufactured by J.A. Woollam Inc.).

(Cracking limitation in coating thickness)

After coating a silicon wafer, 4 inch (10.16 cm) in diameter and 0.5 mm in thickness, with a polyalkylsilazane solution by a spin coating method, the resulting coating was converted into a silica coating in accordance with the method of the Examples or Comparative Examples. Samples having coating different thicknesses within a range from about 0.5 to 3 μm were made by controlling the polysilazane concentration of the polyalkylsilazane solution or the rotational speed of a spin coater. The baked thin coating was observed by a microscope (magnification: ×120) and it was determined whether or not cracking occurred. A maximum coating thickness where no cracking occurs was taken as a cracking limitation to coating thickness.

(Modulus/Nanoindentation method)

After coating a silicon wafer, 4 inch (10.16 cm) in diameter and 0.5 mm in thickness, with a polyalkylsilazane solution by a spin coating method, the resulting coating was converted into a silica coating in accordance with the method of the Examples or Comparative Examples. The modulus of the resulting silica coating was measured by a mechanical properties-evaluating system for thin films (Nano Indenter manufactured by Nano Instruments Inc.).

(Etching rate)

The etching rate was calculated by measuring the thickness by a spectroellipsometer (M-44 manufactured by J.A. Woollam Inc.), and dividing the thickness by a chemical-treatment time (min). The chemicals used in the determination of the etching rate are described in the Examples below.

Reference Example 1 [Synthesis (1) of polymethylsilazane]

A tank reactor made of stainless steel having an internal volume of 5 L was equipped with a stainless tank for feeding a raw material. After replacing the atmosphere of the inside of the reactor with dry nitrogen, 780 g of methyltrichlorosilane was charged into the stainless tank for feeding a raw material, and introduced to the tank reactor, by a force-feed system, using nitrogen. Then, a pyridine-containing tank for feeding a raw material was connected to the reactor, and 4 kg of pyridine was similarly force-fed using nitrogen. The pressure in the reactor was adjusted to 1.0 $kg/cm^2$, and the temperature of the mixed liquid in the reactor was controlled to -4° C. Ammonia was bubbled into the liquid while stirring, and the feed of ammonia was stopped when the pressure in the reactor reached 2.0 $kg/cm^2$. An exhaust line was opened to reduce the pressure in the reactor, and subsequently dry nitrogen was bubbled into the liquid layer for one hour, thereby to remove excess ammonia.

The resulting product was removed by filtering through a pressure funnel under pressure in a dry nitrogen atmosphere to obtain 3200 ml of a filtrate. Pyridine was distilled off by an evaporator to obtain about 340 g of polymethylsilazane.

The number-average molecular weight of the resulting polymethylsilazane was measured by GPC (developing solution: $CHCl_3$). As a result, it was 1800 as calibrated with polystyrene standards. An IR (infrared absorption) spectrum showed absorptions based on N-H at wave numbers of approximately 3350 and 1200 $cm^{-1}$, absorptions based on Si-C at 2900 and 1250 $cm^{-1}$, and an absorption based on Si-N-Si at 1020 to 820 $cm^{-1}$.

Reference Example 2 [Synthesis (2) of polymethylsilazane]

A similar procedure as in the above Reference Example 1 was repeated, except that 780 g of methyltrichlorosilane was replaced with a mixture of 720 g of methyltrichlorosilane and 65 g of dimethyldichlorosilane, thereby to produce about 370 g of polymethylsilazane.

The number-average molecular weight of the resulting polymethylsilazane was measured by GPC (developing solution: $CHCl_3$). As a result, it was 1400 as calibrated with polystyrene standards. An IR (infrared absorption) spectrum showed absorptions based on N-H at wave numbers of approximately 3350 and 1200 $cm^{-1}$, absorptions based on Si-C at 2900 and 1250 $cm^{-1}$, and an absorption based on Si-N-Si at 1020 to 820 $cm^{-1}$.

Reference Example 3 [Synthesis of perhydropolysilazane]

A four-necked flask having an internal volume of 2 L was equipped with a gas bubbling tube, a mechanical scaler and a Dewar condenser. After replacing the atmosphere of a reaction vessel by dry nitrogen, 1500 ml of dry pyridine was charged in the four-necked flask and then ice-cooled. 100 g of dichlorosilane was added to produce an adduct as a white solid ($SiH_2Cl_2 \cdot 2C_5H_5N$). The reaction mixture was ice-cooled and 70 g of ammonia was bubbled into the reaction mixture while stirring. Subsequently, dry nitrogen was bubbled into the aqueous layer for 30 minutes to remove excess ammonia.

The resulting product was removed by filtering through a Buchner funnel under reduced pressure in a dry nitrogen atmosphere to obtain 1200 ml of a filtrate. Pyridine was distilled off by an evaporator to obtain 40 g of perhydropolysilazane.

The number-average molecular weight of the resulting perhydropolysilazane was measured by GPC (developing solution: $CDCl_3$). As a result, it was 800 as calibrated with polystyrene standards. An IR (infrared absorption) spectrum showed absorptions based on N-H at wave numbers of approximately 3350 and 1200 $cm^{-1}$, an absorption based on Si-H at 2170 $cm^{-1}$, and an absorption based on Si-N-Si at 1020 to 820 $cm^{-1}$.

Example 1 (Reference Example 1/polyisobutyl methacrylate = 4:1)

80 g of a 15% solution, in dibutyl ether, of the polymethylsilazane prepared in Reference Example 1 was mixed with a solution, in 17 g of dibutyl ether, of 3 g of polyisobutyl methacrylate having a molecular weight of about 160,000, and the mixture was well stirred. Subsequently, the solution was filtered through a PTFE syringe filter having a filtration accuracy of 0.2 μm manufactured by Advantech Co., Ltd. The filtrate was coated on a silicon wafer of 10.2 cm (4 inch) in diameter and 0.5 mm in thickness using a spin coater (2000 rpm, 20 seconds), and then dried at room temperature

(5 minutes). The silicon wafer was heated on a hot plate at 150°C, then at 280°C in atmospheric air (25°C, relative humidity: 40%) each for 3 minutes. The coating was left to stand in atmospheric air (25°C, relative humidity: 40%) for 24 hours, and then was baked in a dry nitrogen atmosphere at 400°C for 30 minutes. An IR (infrared absorption) spectrum mainly showed absorptions based on Si-O at wave numbers of 1020 and 450 $cm^{-1}$, absorptions based on Si-C at wave numbers of 1270 and 780 $cm^{-1}$, and an absorption based on C-H at a wave number of 2970 $cm^{-1}$, while absorptions based on N-H at wave numbers of 3350 and 1200 $cm^{-1}$ and an absorption based on the polyisobutyl methacrylate disappeared.

The resulting coating was evaluated. As a result, the coating had a specific dielectric constant of 2.2, a density of 1.0 $g/cm^3$, an internal stress of $3.0 \times 10^8$ $dyne/cm^2$, and a cracking limitation in coating thickness of at least 5 $\mu m$. The resulting coating was left to stand in atmospheric air under the conditions of a temperature of 23°C and a relative humidity of 50% for a week and the specific dielectric constant was measured again. As a result, it remained unchanged.

The coating had a modulus determined by the nanoindentation method of 2.6 GPa.

Further, a durability (compatibility) test with ACT-970 (Ashland Chemical Inc.), ST-210, ST-250 (ATMI Inc.), EKC265, EKC640 (EKC Inc.), which are widely used as removers for etch residues, was conducted for the silica coating. As a result, the etching rate was 0.7Å/min or less in each case, and the increase in dielectric constant with this test was within 1.3%.

Example 2 (Reference Example 2/BR1122 = 2:1, aluminum tris(ethyl acetoacetate))

160 g of a 20% solution, in dibutyl ether, of the polymethylsilazane prepared in Reference Example 2 was mixed with a solution, in 32 g of dibutyl ether, of 8 g of a methacrylate (BR1122 manufactured by Mitsubishi rayon Inc.), and the mixture was well stirred. 5 g of aluminum tris(ethyl acetoacetate) was mixed with 95 g of dibutyl ether into solution, and then 24 g of the solution was removed and mixed into the polymethylsilazane solution, and the mixture was well stirred. Subsequently, the solution was filtered through a PTFE syringe filter having a filtration accuracy of 0.2 $\mu m$ manufactured by Advantech Co., Ltd. The filtrate was coated on a silicon wafer of 20.3 cm (8 inch) in diameter and 1 mm in thickness using a spin coater (2000 rpm, 20 seconds), and then dried at room temperature (5 minutes). The silicon wafer was heated on a hot plate at 150°C, then at 220°C, and then at 280°C in atmospheric air (25°C, relative humidity: 40%) each for 3 minutes. The coating was baked in a dry nitrogen atmosphere at 400°C for 10 minutes. An IR (infrared absorption) spectrum mainly showed absorptions based on Si-O at wave numbers of 1020 and 450 $cm^{-1}$, absorptions based on Si-C at wave numbers of 1280 and 780 $cm^{-1}$, and an absorption based on C-H at a wave number of 2980 $cm^{-1}$, while absorptions based on N-H at wave numbers of 3350 and 1200 $cm^{-1}$ and an absorption based on the BR1122 disappeared.

The resulting coating was evaluated. As a result, the coating had a specific dielectric constant of 2.1, a density of 0.9 $g/cm^3$, an internal stress of $2.8 \times 10^8$ $dyne/cm^2$, and a cracking limitation in coating thickness of at least 5 $\mu m$. The resulting coating was left to stand in atmospheric air under the conditions of a temperature of 23°C and a relative humidity of 50% for a week and the specific dielectric constant was measured again. As a result, it remained unchanged.

The coating had a modulus determined by the nanoindentation method of 2.5 GPa.

Further, a compatibility test with ACT-970 (Ashland Chemical Inc.), ST-210, ST-250 (ATMI Inc.), which are widely used as removers for etch residues, was conducted for the silica coating. As a result, the etching rate was 0.8Å/min or less in each case, and the increase in dielectric constant with this test was within 1.6%.

Example 3 (Reference Example 1/PnBMA = 3:1)

90 g of a 16% solution, in dibutyl ether, of the polymethylsilazane prepared in Reference Example 1 was mixed with 30 g of a 16% solution, in dibutyl ether, of poly n-butyl methacrylate having a molecular weight of about 140,000, and the mixture was well stirred. Subsequently, the solution was filtered through a PTFE syringe filter having a filtration accuracy of 0.2 $\mu m$ manufactured by Advantech Co., Ltd. The filtrate was coated on a silicon wafer of 20.3 cm (8 inch) in diameter and 1 mm in thickness using a spin coater (2200 rpm, 20 seconds), and then dried at room temperature (5 minutes). The silicon wafer was heated on a hot plate at 150°C, then at 280°C in atmospheric air (25°C, relative humidity: 40%) each for 3 minutes. The coating was left to stand in atmospheric air (22.5°C, relative humidity: 54%) for 24 hours, and then was baked in a dry nitrogen atmosphere at 400°C for 10 minutes. An IR (infrared absorption) spectrum mainly showed absorptions based on Si-O at wave numbers of 1020 and 450 $cm^{-1}$, absorptions based on Si-C at wave numbers of 1270 and 780 $cm^{-1}$, and an absorption based on C-H at a wave number of 2970 $cm^{-1}$, while absorptions based on N-H at wave numbers of 3350 and 1200 $cm^{-1}$ and an absorption based on the poly n-butyl methacrylate disappeared.

The resulting coating was evaluated. As a result, the coating had a specific dielectric constant of 2.0, a density of 1.0 $g/cm^3$, an internal stress of $2.8 \times 10^8$ $dyne/cm^2$, and a cracking limitation in coating thickness of at least 5 $\mu m$. The resulting coating was left to stand in atmospheric air under the conditions of a temperature of 23°C and a relative humidity of 50% for a week and the specific dielectric constant was measured again. As a result, it remained unchanged.

The coating had a modulus determined by the nanoindentation method of 2.5 GPa.

Further, a compatibility test with ACT-970 (Ashland Chemical Inc.) which is widely used as a remover for etch residues, was conducted for the silica coating. As a result, the etching rate was 0.8Å/min, and the dielectric constant after this test was 2.0.

Comparative Example 1 (methylsiloxane polymer/BR1122 = 4:1)

45 g of tetramethoxysilane, 140 g of methyltrimethoxysilane and 18 g of dimethyldimethoxysilane were dissolved in 615 g of isopropyl alcohol, and to the solution was added, dropwise, 60 g of 0.3 N aqueous solution of phosphoric acid so as to cause hydrolysis, thereby to produce a methylsiloxane polymer. 40 g of the polymer solution was mixed with 10 g of 20% solution of a methacrylate (BR1122 manufactured by Mitsubishi rayon Inc.) in isopropyl alcohol, and the mixture was well stirred. Subsequently, the solution was filtered through a PTFE syringe filter, having a filtration accuracy of 0.2 μm, manufactured by Advantech Co., Ltd. The filtrate was coated on a silicon wafer of 20.3 cm (8 inch) in diameter and 1 mm in thickness using a spin coater (1200 rpm, 20 seconds), and then dried at room temperature (5 minutes). The silicon wafer was heated on a hot plate at 100°C, then at 280°C in atmospheric air (25°C, relative humidity: 40%) each for 3 minutes. The coating was baked in a dry nitrogen atmosphere at 400°C for 30 minutes. An IR (infrared absorption) spectrum mainly showed absorptions based on Si-O at wave numbers of 1020 and 460 $cm^{-1}$, absorptions based on Si-C at wave numbers of 1280 and 780 $cm^{-1}$, and an absorption based on C-H at a wave number of 2980 $cm^{-1}$, while an absorption based on the BR1122 disappeared.

The resulting coating was evaluated. As a result, the coating had a specific dielectric constant of 2.3, a density of 1.8 $g/cm^3$, an internal stress of $2.2 \times 10^8$ $dyne/cm^2$, and a cracking limitation in coating thickness of at least 1.5 μm. The resulting coating was left to stand in atmospheric air under the conditions of a temperature of 23°C and a relative humidity of 50% for a week and the specific dielectric constant was measured again. As a result, it remained unchanged.

The coating had a modulus determined by the nanoindentation method of 1.8 GPa.

Further, a compatibility test with ACT-970 (Ashland Chemical Inc.) which is widely used as a remover for etch residues, was conducted for the silica coating. As a result, the etching rate was 3.4Å/min, and the dielectric constant was increased to 2.5 with this test.

Comparative Example 2 (PPSZ-1, LPSZ-1 (0.3)/PMMA = 4:1, tri(isopropoxy)aluminum)

60 g of perhydropolysilazane prepared in Reference Example 3 was dissolved in 240 g of xylene to make a polysilazane solution. 3 g of tri(isopropoxy)aluminum was mixed with 147 g of xylene into solution, and then 6 g of the solution was removed and mixed into the polysilazane solution. A solution, in 60 g of xylene, of 15 g of polymethyl methacrylate having a molecular weight of 100,000 was mixed with the above polysilazane solution, and the mixture was well stirred. Subsequently, the solution was filtered through a PTFE syringe filter, having a filtration accuracy of 0.2 μm, manufactured by Advantech Co., Ltd. The filtrate was coated on a silicon wafer of 10.2 cm (4 inch) in diameter and 0.5 mm in thickness using a spin coater (2300 rpm, 20 seconds), and then dried at room temperature (5 minutes). The silicon wafer was heated on a hot plate at 150°C, then at 220°C in atmospheric air (25°C, relative humidity: 40%) each for 3 minutes. The coating was baked in a dry nitrogen atmosphere at 400°C for 30 minutes. An IR (infrared absorption) spectrum mainly showed absorptions based on Si-O at wave numbers of 1070 and 450 $cm^{-1}$, and absorptions based on Si-H at wave numbers of 2250 and 880 $cm^{-1}$, while absorptions based on N-H at wave numbers of 3350 and 1200 $cm^{-1}$ and an absorption based on the polymethyl methacrylate disappeared.

The resulting coating was evaluated. As a result, the coating had a specific dielectric constant of 1.8, a density of 1.0 $g/cm^3$, an internal stress of $2.7 \times 10^8$ $dyne/cm^2$, and a cracking limitation in coating thickness of at least 5 μm. The resulting coating was left to stand in atmospheric air under the conditions of a temperature of 23°C and a relative humidity of 50% for a week and the specific dielectric constant was measured again. As a result, it increased by 0.1 to 1.9.

The coating had a modulus determined by the nanoindentation method of 1.9 GPa.

Further, a compatibility test with ACT-970 (Ashland Chemical Inc.), ST-210, ST-250 (ATMI Inc.), which are widely used as removers for etch residues, was conducted for the silica coating. As a result, the etching rate could not be measured, because the coating disappeared for each of the chemicals.

INDUSTRIAL APPLICABILITY

The porous silica coating obtained by the method of the present invention stably exhibits an extremely low specific dielectric constant, and also has resistance to various chemicals and a mechanical strength which allow the coating to withstand the step of removing wiring materials by a CMP process, and therefore it is particularly useful as an interlayer dielectric for semiconductor devices which is compatible with the latest highly integrating process including the Damascene process.

## Claims

**1.** A method for preparing a porous silica coating having a specific dielectric constant of less than 2.5, by baking a coating of a composition comprising a polyalkylsilazane and a polyacrylic or polymethacrylic ester, wherein the polyalkylsilazane has a repeating unit represented by the following general formula (1) and/or general forumula (2) and a number-average molecular weight within a range from 100 to 50.000:

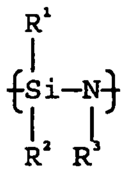

(1)

wherein, $R^1$, $R^2$ and $R^3$ each independently represents a hydrogen atom or an alkyl group having 1 to 3 carbon atoms, provided that $R^1$ and $R^2$ cannot be hydrogen atoms at the same time;

$$-(SiR^4(NR^5)_{1.5})- \qquad (2)$$

wherein, $R^4$ and $R^5$ each independently represents a hydrogen atom or an alkyl group having 1 to 3 carbon atoms, provided that $R^4$ and $R^5$ cannot be hydrogen atoms at the same time.

**2.** The method according to claim 1, wherein $R^1$ and $R^2$ each independently is a hydrogen atom or a methyl group and $R^3$ is a hydrogen atom in the formula (1), and $R^4$ is a methyl group and $R^5$ is a hydrogen atom in the formula (2).

**3.** The method according to claim 1, wherein the polyalkylsilazane has both repeating units represented by the formulae (1) and (2) and a number-average molecular weight within a range from 100 to 50,000, the number of repeating units represented by the formula (2) comprising at least 50% of the total number of repeating units represented by the formulae (1) and (2).

**4.** The method according to claim 3, wherein the number of repeating units represented by the formula (2) comprises at least 80% of the total number of repeating units represented by the formulae (1) and (2).

**5.** The method according to claim 1, wherein the polyalkylsilazane is an aluminum-containing polyalkylsilazane.

**6.** The method according to claim 1, wherein the polyacrylic or polymethacrylic ester has a number-average molecular weight within a range from 1,000 to 800,000.

**7.** The method according to claim 1, wherein the amount of the polyacrylic or polymethacrylic ester in the composition is within a range from 5 to 150% by weight based on the polyalkylsilazane.

**8.** The method according to claim 1, wherein the composition further contains an aluminum compound in an amount within a range from 0.001 to 10% by weight as aluminum based on the polyalkylsilazane.

**9.** The method according to claim 1 comprising pre-baking a polyalkylsilazane coating, which is obtained by coating a substrate with the coating composition comprising, in an organic solvent, the polyalkylsilazane and the polyacrylic or polymethacrylic ester, in a water vapor-containing atmosphere at a temperature of from 50 to 300°C, and then baking the coating in a dry atmosphere at a temperature of from 300 to 500°C.

**10.** The method according to claim 9, wherein the preliminary baked polyalkylsilazane coating is left to stand in atmospheric air before baking the coating.

## Patentansprüche

**1.** Verfahren zur Herstellung einer porösen Silica-Beschichtung mit einer spezifischen dielektrischen Konstante von weniger als 2,5 durch Erhitzen einer Schicht einer Zusammensetzung, enthaltend ein Polyalkylsilazan und einen Polyacryl- oder Polymethacrylester, wobei das Polyalkylsilazan eine Repetiereinheit der folgenden allgemeinen

Formel (1) und/oder allgemeinen Formel (2) und ein zahlenmittleres Molekulargewicht im Bereich von 100 bis 50.000 aufweist:

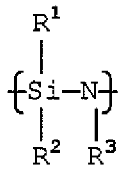

(1)

wobei $R^1$, $R^2$ und $R^3$ jeweils unabhängig voneinander ein Wasserstoffatom oder eine Alkylgruppe mit 1 bis 3 Kohlenstoffatomen darstellen, mit der Maßgabe, dass $R^1$ und $R^2$ nicht gleichzeitig Wasserstoffatome sind;

$$-(SiR^4(NR^5)_{1,5})- \qquad (2)$$

wobei $R^4$ und $R^5$ jeweils unabhängig voneinander ein Wasserstoffatom oder eine Alkylgruppe mit 1 bis 3 Kohlenstoffatomen darstellen, mit der Maßgabe, dass $R^4$ und $R^5$ nicht gleichzeitig Wasserstoffatome sind.

**2.** Verfahren gemäß Anspruch 1, wobei in der Formel (1) $R^1$ und $R^2$ jeweils unabhängig voneinander ein Wasserstoffatom oder eine Methylgruppe sind und $R^3$ ein Wasserstoffatom ist und in der Formel (2) $R^4$ eine Methylgruppe ist und $R^5$ ein Wasserstoffatom ist.

**3.** Verfahren gemäß Anspruch 1, wobei das Polyalkylsilazan sowohl Repetiereinheiten der Formel (1) als auch Repetiereinheiten der Formel (2) und ein zahlenmittleres Molekulargewicht im Bereich von 100 bis 50.000 aufweist, wobei die Zahl an Repetiereinheiten der Formel (2) mindestens 50% der Gesamtzahl an Repetiereinheiten der Formeln (1) und (2) umfasst.

**4.** Verfahren gemäß Anspruch 3, wobei die Zahl an Repetiereinheiten der Formel (2) mindestens 80% der Gesamtzahl an Repetiereinheiten der Formeln (1) und (2) umfasst.

**5.** Verfahren gemäß Anspruch 1, wobei das Polyalkylsilazan ein Aluminium enthaltendes Polyalkylsilazan ist.

**6.** Verfahren gemäß Anspruch 1, wobei der Polyacryl- oder Polymethacrylester ein zahlenmittleres Molekulargewicht im Bereich von 1.000 bis 800.000 aufweist.

**7.** Verfahren gemäß Anspruch 1, wobei die Menge des Polyacryl- oder Polymethacrylesters in der Zusammensetzung im Bereich von 5 bis 150 Gew.-%, bezogen auf das Polyalkylsilazan, liegt.

**8.** Verfahren gemäß Anspruch 1, wobei die Zusammensetzung zusätzlich eine Aluminiumverbindung in einer Menge im Bereich von 0,001 bis 10 Gew.-% Aluminium, bezogen auf das Polyalkylsilazan, enthält.

**9.** Verfahren gemäß Anspruch 1, umfassend das Vorerhitzen einer Polyalkylsilazanschicht, die erhalten wird durch Überziehen eines Substrats mit der Beschichtungszusammensetzung, enthaltend, in einem organischen Lösungsmittel, das Polyalkylsilazan und den Polyacryl- oder Polymethacrylester, in einer Wasserdampf enthaltenden Atmosphäre bei einer Temperatur von 50 bis 300°C, gefolgt von dem Erhitzen der Schicht in einer trockenen Atmosphäre bei einer Temperatur von 300 bis 500°C.

**10.** Verfahren gemäß Anspruch 9, wobei die vorerhitzte Polyalkylsilazanschicht in atmosphärischer Luft stehengelassen wird, bevor die Schicht erhitzt wird.

## Revendications

**1.** Procédé de préparation d'un revêtement poreux de silice ayant une constante diélectrique spécifique inférieure à 2,5, par cuisson d'un revêtement d'une composition comprenant un polyalkylsilazane et un ester polyacrylique ou polyméthacrylique, le polyalkylsilazane ayant un motif répétitif représenté par la formule générale (1) et/ou la formule

générale (2) suivantes et un poids moléculaire moyen en nombre dans une gamme de 100 à 50 000 :

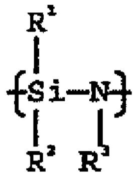

(1)

dans laquelle $R^1$, $R^2$ et $R^3$ représentent chacun indépendamment un atome d'hydrogène ou un groupe alkyle ayant 1 à 3 atomes de carbone, à condition que $R^1$ et $R^2$ ne puissent pas être des atomes d'hydrogène en même temps ;

$$-(SiR^4(NR^5)_{1,5})- \qquad (2)$$

dans laquelle $R^4$ et $R^5$ représentent chacun indépendamment un atome d'hydrogène ou un groupe alkyle ayant 1 à 3 atomes de carbone, à condition que $R^4$ et $R^5$ ne puissent pas être des atomes d'hydrogène en même temps.

**2.** Procédé selon la revendication 1, dans lequel $R^1$ et $R^2$ sont chacun indépendamment un atome d'hydrogène ou un groupe méthyle et $R^3$ est un atome d'hydrogène dans la formule (1), et $R^4$ est un groupe méthyle et $R^5$ est un atome d'hydrogène dans la formule (2).

**3.** Procédé selon la revendication 1, dans lequel le polyalkylsilazane a deux motifs répétitifs représentés par les formules (1) et (2) et un poids moléculaire moyen en nombre dans une gamme de 100 à 50 000, le nombre de motifs répétitifs représentés par la formule (2) constituant au moins 50 % du nombre total de motifs répétitifs représentés par les formules (1) et (2).

**4.** Procédé selon la revendication 3, dans lequel le nombre de motifs répétitifs représentés par la formule (2) constitue au moins 80 % du nombre total de motifs répétitifs représentés par les formules (1) et (2).

**5.** Procédé selon la revendication 1, dans lequel le polyalkylsilazane est un polyalkylsilazane contenant de l'aluminium.

**6.** Procédé selon la revendication 1, dans lequel l'ester polyacrylique ou polyméthacrylique a un poids moléculaire moyen en nombre dans une gamme de 1000 à 800 000.

**7.** Procédé selon la revendication 1, dans lequel la quantité d'ester polyacrylique ou polyméthacrylique dans la composition se situe dans une gamme de 5 à 150 % en poids, rapporté au polyalkylsilazane.

**8.** Procédé selon la revendication 1, dans lequel la composition contient également un composé d'aluminium dans une quantité dans une gamme de 0,001 à 10 % en poids d'aluminium, rapporté au polyalkylsilazane.

**9.** Procédé selon la revendication 1 comprenant la pré-cuisson d'un revêtement de polyalkylsilazane qui est obtenu en recouvrant un substrat avec la composition de revêtement comprenant, dans un solvant organique, le polyalkylsilazane et l'ester polyacrylique ou polyméthacrylique, dans une atmosphère contenant de la vapeur d'eau à une température de 50 à 300 °C, puis en cuisant le revêtement dans une atmosphère sèche à une température de 300 à 500 °C.

**10.** Procédé selon la revendication 9, dans lequel le revêtement de polyalkylsilazane préalablement cuit est laissé au repos dans l'air atmosphérique avant de cuire le revêtement.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 11105185 A